# EUROPÄISCHE PATENTSCHRIFT

(11) **EP 2 057 722 B1**
(45) Veröffentlichungstag und Bekanntmachung des Hinweises auf die Patenterteilung: **10.10.2012**
(21) Anmeldenummer: 07788286.8
(22) Anmeldetag: 07.08.2007
(51) Int. Cl.: H01S 3/0941, H01S 3/131, F02P 23/04, H01S 5/068

(54) **VERFAHREN ZUM BETREIBEN EINER PUMPLICHTQUELLE MIT EINEM DIODENLASER**
METHOD FOR OPERATING A PUMP LIGHT SOURCE WITH A DIODE LASER
PROCEDE DE FONCTIONNEMENT D'UNE SOURCE DE LUMIERE DE POMPAGE MUNIE D'UNE DIODE LASER

(30) Priorität: 22.08.2006 DE 102006039398
(43) Veröffentlichungstag der Anmeldung: 13.05.2009
(73) Patentinhaber: Robert Bosch GmbH, 70442 Stuttgart (DE)
(72) Erfinder: VOGEL, Manfred, 71254 Ditzingen (DE); HERDEN, Werner, 70839 Gerlingen (DE); RIDDERBUSCH, Heiko, 71701 Schwieberdingen (DE)
(86) Internationale Anmeldenummer: PCT/EP2007/058186
(87) Internationale Veröffentlichungsnummer: WO 2008/022914

(56) Entgegenhaltungen:
- WO-A-2005/028856
- WO-A-2005/066488
- US-A- 5 400 351
- US-A- 5 926 495
- US-A1- 2006 018 350

## Beschreibung

### Stand der Technik

Die Erfindung betrifft ein Verfahren zum Betreiben einer Pumplichtquelle mit einem Diodenlaser, die ein Pumplicht bereitstellt, insbesondere zum optischen Pumpen einer Lasereinrichtung.

Derartige Verfahren sind bekannt und umfassen üblicherweise eine aktive Kühlung und/oder Heizung des Diodenlasers beziehungsweise der Pumplichtquelle, um die von der Temperatur des Diodenlasers abhängige Wellenlänge des Pumplichts für einen Betrieb zu stabilisieren. Die Temperierung des Diodenlasers kann beispielsweise durch Peltier-Elemente oder auch unter Verwendung einer Wasserkühlung erfolgen. Ein derartiger Aufwand zur Temperierung des Diodenlasers ist jedoch in vielen Anwendungsbereichen, insbesondere bei einer Verwendung der Pumplichtquelle in dem Kraflfahraeugbereich, nicht wirtschaftlich. Zum Stand der Technik wird auf die US-A-5 926 495, die US-A-5400 351, die WO 2005/02 8856A, die WO 2005/066 488 A und die US 2006/018 350 A1 verwiesen.

### Offenbarung der Erfindung

Demgemäß ist es Aufgabe der vorliegenden Erfindung, ein Betriebsverfahren der eingangs genannten Art dahingehend zu verbessern, dass eine gesteigerte Stabilität der Wellenlänge des von der Pumplichtquelle erzeugten Pumplichts auch ohne den Einsatz einer aktiven Temperierung der Pumplichtquelle beziehungsweise des darin enthaltenen Diodenlasers gewährleistet ist.

Diese Aufgabe wird bei einem Verfahren der eingangs genannten Art erfindungsgemäß in dem Verfahren nach Anspruch 1 dadurch gelöst, dass die Pumplichtquelle in einer ersten Betriebsart so angesteuert wird, dass der Diodenlaser auf eine vorgebbare Zieltemperatur aufheizt.

### Vorteile der Erfindung

Die erfindungsgemäße Ansteuerung der Pumplichtquelle in der ersten Betriebsart bewirkt vorteilhaft eine Temperierung des Diodenlasers unter Ausnutzung der elektrischen Energie, die der Pumplichtquelle bei ihrer Ansteuerung zugeführt wird, so dass der Diodenlaser auch ohne den Einsatz aktiver Heiz- beziehungsweise Kühlmittel eine gewünschte Zieltemperatur annehmen kann. Damit ist durch das erfindungsgemäße Betriebsverfahren in besonders einfacher Weise gewährleistet, dass die von der Temperatur des Diodenlasers abhängige Wellenlänge des Pumplichts einen für den weiteren Betrieb der Pumplichtquelle gewünschten beziehungsweise vorgebbaren Wert aufweist und auch beibehalten kann.

Im Gegensatz zu der aufwendigen aktiven Temperierung bei herkömmlichen Systemen, die entsprechende Zusatzkomponenten wie einen Kühlkreisläuf oder ein Peltier-Element erfordert, sieht das erfindungsgemäße Betriebsverfahren vorteilhaft lediglich eine besondere Ansteuerung der Pumplichtquelle in der ersten Betriebsart vor, um den Diodenlaser auf die vorgebbare Zieltemperatur und damit auch die entsprechende Wellenlänge zu bringen.

Erfindungsgemäβ werden ein Ansteuerstrom und eine Ansteuerdauer, für die der Diodenlaser mit dem Ansteuerstrom beaufschlagt wird, vorzugsweise in Abhängigkeit der Zieltemperatur, vorgegeben. Eine derartige Vorsteuerung ist bei bekannter Ausgangstemperatur des Diodenlasers und ggf. unter Kenntnis seiner Wärmekapazität in vielen Fällen ausreichend, um die Zieltemperatur mit einer hinreichenden Genauigkeit zu erreichen.

Um eine besonders effektive Temperierung des Diodenlasers zu erzielen, wird der Ansteuerstrom so gewählt, dass er in dem Bereich eines Schwellstroms des Diodenlasers liegt. Vorzugsweise ist der Ansteuerstrom etwa kleiner oder gleich dem zweifachen Schwellstrom. Untersuchungen der Anmelderin haben ergeben, dass ein besonders wirksames Aufheizen des Diodenlasers bei einer Beaufschlagung mit einem derartigen Ansteuerstrom möglich ist.

Zur effektiven. Erzeugung von Pumplicht einer gewünschten Wellenlänge ist erfindungsgemäß vorgesehen, dass der Diodenlaser in einer zweiten Betriebsart angesteuert wird, um Pumplicht zu erzeugen, insbesondere mit einem Ansteuerstrom, der, vorzugsweise um ein Vielfaches, größer ist als der Schwellstrom des Diodenlasers. Dadurch wird der Diodenlaser mit einem gegenüber der ersten Betriebsart gesteigerten Wirkungsgrad betrieben.

Aufgrund der sehr einfachen Temperierung durch Einstellung der Ansteuerparameter und der damit einhergehenden Stabilität einer Wellenlänge des Pumplichts kann eine erfindungsgemäß betriebene Pumplichtquelle sehr vorteilhaft verwendet werden zum optischen Pumpen einer Lasereinrichtung einer Zündeinrichtung für eine Brennkraftmaschine, insbesondere eines Kraftfahrzeugs, wobei die Lasereinrichtung einen laseraktiven Festkörper mit einer passiven Güteschaltung aufweist. Durch die erfindungsgemäß erzielbare Konstanz der Wellenlänge des Pumplichts lässt sich bei Lasereinrichtungen dieses Typs vorteilhaft ein zeitlicher Jitter der erzeugten Laserimpulse minimieren, so dass die genauere Einhaltung eines Zündzeitpunkts ermöglicht ist.

Um die Pumplichtquelle ihrem Anwendungsbereich entsprechend zu konfigurieren, wird erfindungsgemäß vorteilhaft eine Zieltemperatur vorgegeben, bei der das von der Pumplichtquelle erzeugte Pumplicht eine gewünschte Wellenlänge beziehungsweise eine Wellenlänge aufweist, die in einem Bereich eines Maximums des Absorptionskoeffizienten des laseraktiven Festkörpers der Lasereinrichtung liegt, so dass ein besonders effizientes Pumpen des laseraktiven Festkörpers möglich ist.

Ein effizientes Pumpen der Lasereinrichtung ist dadurch möglich, dass die Pumplichtquelle in einer auf die erste Betriebsart erfolgende zweite Betriebsart so angesteuert wird, dass sie Pumplicht erzeugt, um eine Besetzungsinversion in dem laseraktiven Festkörper der Lasereinrichtung aufzubauen. Besonders vorteilhaft wird einer weiteren Erfindungsvariante zufolge der Ansteuerstrom und/oder die Ansteuerdauer in der zweiten Betriebsart so gewählt, dass sich in der Lasereinrichtung kein Laser-Betrieb einstellt, wodurch sichergestellt wird, dass eine maximale Besetzungsinversion für die zukünftige Erzeugung eines Laserimpulses aufgebaut wird.

Um den zeitlichen Jitter bei der Erzeugung eines Laserimpulses durch die Lasereinrichtung möglichst gering zu halten, ist erfindungsgemäß vorteilhaft vorgesehen, dass in einer auf die zweite Betriebsart folgenden dritten Betriebsart die Pumplichtquelle so angesteuert wird, dass sie Pumplicht derart erzeugt, um einen Laser-Betrieb in der Lasereinrichtung zu aktivieren. Die erfindungsgemäße Trennung zwischen der zweiten und der dritten Betriebsart ermöglicht vorteilhaft das zuverlässige Erzeugen eines Laserimpulses allein während der Ansteuerdauer der dritten Betriebsart, wobei die entsprechende Ansteuerdauer vorteilhaft vergleichsweise gering gewählt werden kann, so dass sich eine effektive Verringerung des zeitlichen Jitters bei der Erzeugung des Laserimpulses ergibt. Die sichere Aktivierung des Laser-Betriebs in der dritten Betriebsart wird erfindungsgemäß dadurch sichergestellt, dass ein Ansteuerstrom in der dritten Betriebsart größer ist als ein Ansteuerstrom der zweiten Betriebsart.

Von besonderer Bedeutung ist die Realisierung des erfindungsgemäßen Betriebsverfahrens in Form eines Computerprogramms, das auf einem elektronischen Speichermedium abspeicherbar ist und beispielsweise einem das Betriebsverfahren ausführenden Steuergerät beziehungsweise einer Recheneinheit eines derartigen Steuergeräts zugeordnet sein kann.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind.

### Kurze Beschreibung der Zeichnung

In der Zeichnung zeigt:
- Figur 1: eine schematische Darstellung einer Brennkraftmaschine mit einer erfindungsgemäß betriebenen Pumplichtquelle,
- Figur 2: eine Ausführungsform einer Zündeinrichtung der Brennkraftmaschine aus Figur 1,
- Figur 3a: den zeitlichen Verlauf eines Ansteuerstroms für die Pumplichtquelle gemäß der vorliegenden Erfindung, und
- Figur 3b: den Verlauf eines Absorptionskoeffizienten eines laseraktiven Festkörpers der Lasereinrichtung aus Figur 2 aufgetragen über der Wellenlänge.

### Ausführungsformen der Erfindung

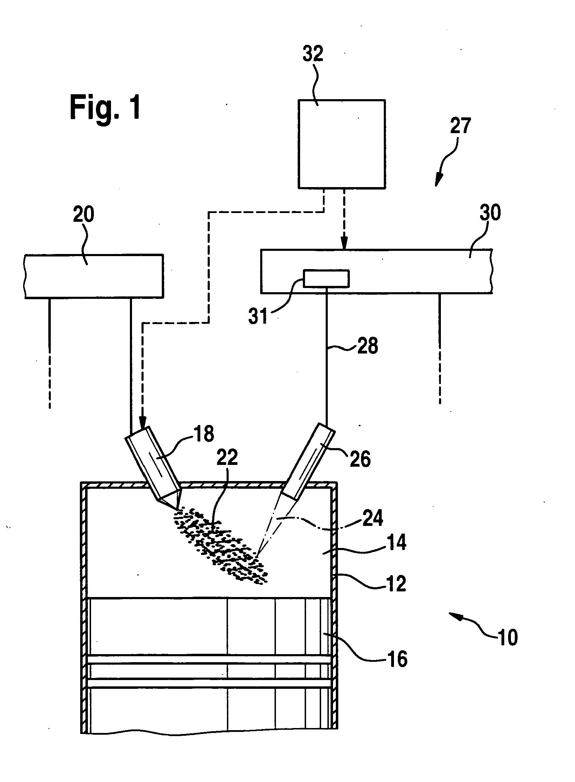

Eine Brennkraftmaschine trägt in Figur 1 insgesamt das Bezugszeichen 10. Sie dient zum Antrieb eines nicht dargestellten Kraftfahrzeugs. Die Brennkraftmaschine 10 umfasst mehrere Zylinder, von denen in Figur 1 nur einer mit dem Bezugszeichen 12 bezeichnet ist. Ein Brennraum 14 des Zylinders 12 wird von einem Kolben 16 begrenzt. Kraftstoff gelangt in den Brennraum 14 direkt durch einen Injektor 18, der an einen auch als Rail beziehungsweise Common-Rail bezeichneten Kraftstoffdruckspeicher 20 angeschlossen ist.

In den Brennraum 14 eingespritzter Kraftstoff 22 wird mittels eines Laserimpulses 24 entzündet, der von einer eine Lasereinrichtung 26 umfassenden Zündeinrichtung 27 in den Brennraum 14 abgestrahlt wird. Hierzu wird die Lasereinrichtung 26 über eine Lichtleitereinrichtung 28 mit einem Pumplicht gespeist, welches von einer Pumplichtquelle 30 bereitgestellt wird. Die Pumplichtquelle 30 weist zur Erzeugung des Pumplichts einen Diodenlaser 31 auf, der wie aus Figur 1 ersichtlich beispielsweise direkt der Lichtleitereinrichtung 28 zugeordnet ist. Eine Ansteuerung der Pumplichtquelle 30 beziehungsweise des Diodenlasers 31 erfolgt durch ein Steuergerät 32, das auch den Injektor 18 ansteuert.

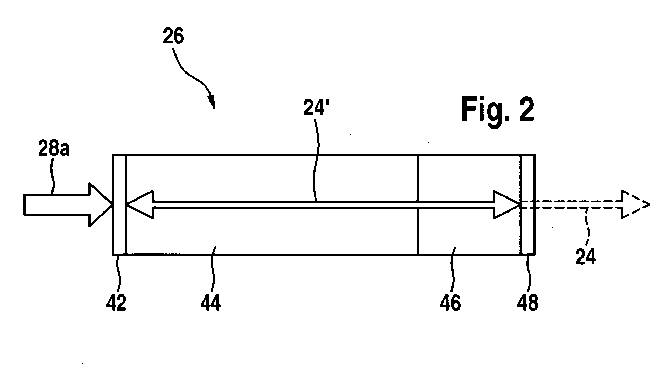

Figur 2 zeigt schematisch eine Detailansicht der Lasereinrichtung 26 aus Figur 1.

Wie aus Figur 2 ersichtlich, weist die Lasereinrichtung 26 einen laseraktiven Festkörper 44 auf, dem eine auch als Q-switch bezeichnete passive Güteschaltung 46 optisch nachgeordnet ist. Der laseraktive Festkörper 44 bildet hierbei zusammen mit der passiven Güteschaltung 46 sowie dem in Figur 2 links hiervon angeordneten Einkoppelspiegel 42 und dem Auskoppelspiegel 48 einen Laser-Oszillator aus, dessen Schwingverhalten in bekannter Weise von der passiven Güteschaltung 46 abhängt.

Bei der in Figur 2 abgebildeten Konfiguration wird die Lasereinrichtung 26 beziehungsweise der laseraktive Festkörper 44 durch den Einkoppelspiegel 42 hindurch mit Pumplicht 28a beaufschlagt, das Elektronen in dem laseraktiven Festkörper 44 anregt und dementsprechend zu einer Besetzungsinversion führt. Das Pumplicht 28a wird der Lasereinrichtung 26 - wie vorstehend bereits unter Bezugnahme auf Figur 1 beschrieben - über die Lichtleitereinrichtung 28 zugeführt, die den Diodenlaser 31 optisch mit der Lasereinrichtung 26 verbindet.

Während die passive Güteschaltung 46 ihren Ruhezustand aufweist, in dem sie einen verhältnismäßig geringen Transmissionskoeffizienten besitzt, wird ein Laser-Betrieb in dem laseraktiven Festkörper 44 beziehungsweise in dem durch den Einkoppelspiegel 42 und den Auskoppelspiegel 48 begrenzten Festkörper 44, 46 vermieden. Mit steigender Pumpdauer, d.h., während einer Beaufschlagung mit dem Pumplicht 28a, steigt jedoch auch die Strahlungsintensität in dem Laser-Oszillator 42, 44, 46, 48 an, so dass die passive Güteschaltung 46 schließlich ausbleicht. Das heißt, ihr Transmissionskoeffizient steigt, und ein Laser-Betrieb in dem Laser-Oszillator 42, 44, 46, 48 beginnt. Dieser Zustand ist durch den Doppelpfeil 24' symbolisiert.

Auf die vorstehend beschriebene Weise entsteht ein auch als Riesenimpuls bezeichneter Laserimpuls 24, der eine verhältnismäßig hohe Spitzenleistung aufweist. Der Laserimpuls 24 wird, gegebenenfalls unter Verwendung einer weiteren Lichtleitereinrichtung (nicht gezeigt), oder auch direkt durch ein ebenfalls nicht abgebildetes Brennraumfenster der Lasereinrichtung 26 in den Brennraum 14 (Figur 1) der Brennkraftmaschine 10 eingekoppelt, so dass darin vorhandener Kraftstoff 22 beziehungsweise ein Luft-/Kraftstoffgemisch entzündet wird.

Um die sichere Erzeugung des Laserimpulses 24 und damit eine sichere Entzündung des Luft-/Kraftstoffgemischs in dem Brennraum 14 der Brennkraftmaschine 10 zu ermöglichten, sieht das erfindungsgemäße Betriebsverfahren vor, dass die Pumplichtquelle 30 (Figur 1) in einer ersten Betriebsart so angesteuert wird, dass der Diodenlaser 31 eine vorgebbare Zieltemperatur annimmt.

Dadurch ist vorteilhaft gewährleistet; dass eine Wellenlänge des Pumplichts 28a, die von der Temperatur des Diodenlasers 31 abhängt, ebenfalls einen vorgebbaren Wert aufweist und ein definiertes Pumpen der Lasereinrichtung 26 mit dem Pumplicht 28a möglich ist.

Besonders vorteilhaft erfordert das erfindungsgemäße Betriebsverfahren somit keine aktiven Kühl- und/oder Heizmittel zur Temperierung des Diodenlasers 31, sondern es wird vielmehr direkt die Ansteuerung der Pumplichtquelle 30 beziehungsweise des Diodenlasers 31 ausgenutzt, um den Diodenlaser 31 zu temperieren.

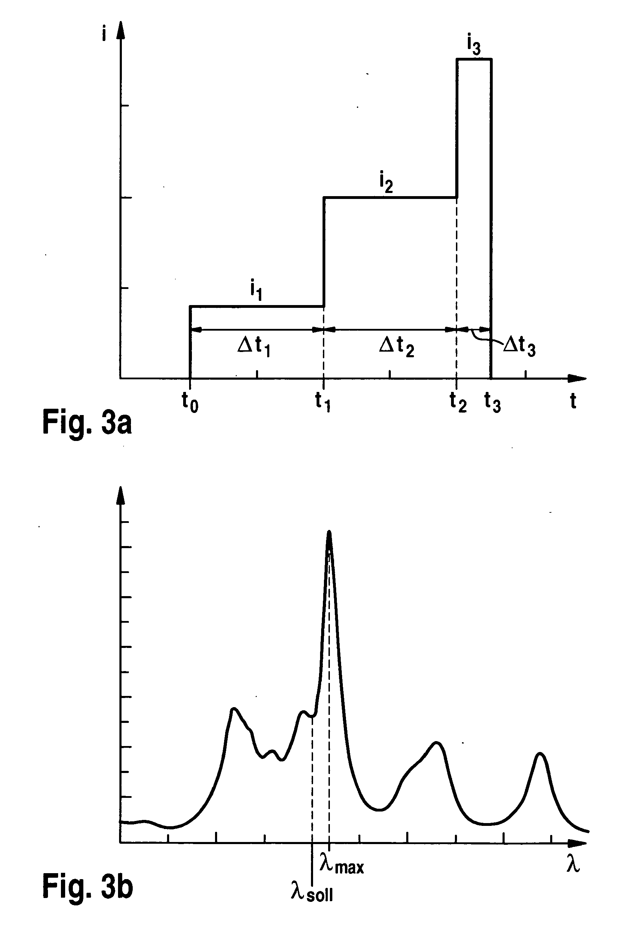

Figur 3a zeigt den zeitlichen Verlauf eines Ansteuerstroms i für den Diodenlaser 31 gemäß einem besonders bevorzugten Ausführungsbeispiel der vorliegenden Erfindung.

Die erfindungsgemäße Ansteuerung des Diodenlasers 31 weist dem Schaubild aus Figur 3a zufolge insgesamt drei verschiedene Phasen beziehungsweise Betriebsarten auf.

Erfindungsgemäß wird die Pumplichtquelle 30 beziehungsweise der Diodenlaser 31 in einer ersten Betriebsart so angesteuert, dass der Diodenlaser 31 eine vorgebbare Zieltemperatur annimmt und damit auch Pumplicht 28a einer bekannten und mit der Zieltemperatur korrespondierenden Wellenlänge abgibt.

Hierzu wird der Diodenlaser 31 wie aus Figur 3a ersichtlich ab dem Zeitpunkt t₀ mit einem Ansteuerstrom i₁ beaufschlagt. Diese Ansteuerung des Diodenlasers 31 dauert bis zu einem Zeitpunkt t₁ an, zu dem der Diodenlaser 31 eine mit der gewünschten Wellenlänge des Pumplichts 28a korrespondierende, vorgebbare Zieltemperatur angenommen hat. Hierdurch ist die Ansteuerdauer Δt₁ für die erste Betriebsart des erfindungsgemäßen Verfahrens definiert.

Die erfindungsgemäße Beaufschlagung des Diodenlasers 31 mit dem Ansteuerstrom i₁ während der Ansteuerdauer Δt₁ der ersten Betriebsart führt dazu, dass von dem Diodenlaser 31 emittiertes Pumplicht 28a eine gewünschte Wellenlänge λₛₒₗₗ aufweist, vergleiche Figur 3b, die einen Absorptionskoeffizienten des laseraktiven Festkörpers 44 über der Wellenlänge λ wiedergibt.

Die gewünschte Wellenlänge λₛₒₗₗ ist derart gewählt, dass sie unmittelbar in dem Bereich einer Wellenlänge λₘₐₓ, vorzugsweise insbesondere unterhalb der Wellenlänge λₘₐₓ, liegt, bei der der laseraktive Festkörper 44 (Figur 2) der Lasereinrichtung 26 seinen maximalen Absorptionskoeffizienten für das Pumplicht 28a aufweist, vergleiche Figur 3b.

Ganz besonders vorteilhaft wird die gewünschte Wellenlänge λₛₒₗₗ deshalb so vorgegeben, dass sie unterhalb der Wellenlänge λₘₐₓ liegt, weil eine aktive Kühlung durch das erfindungsgemäße Betriebsverfahren - außer durch eine ausbleibende Ansteuerung - nicht möglich ist, und eine weitere Erwärmung des Diodenlasers 31 allein durch die Ansteuerung mit den Ansteuerströmen i₂, i₃ während der weiteren Betriebsarten in dem Zeitbereich t > t₁ (Figur 3a) zu erwarten ist.

Dadurch ist gewährleistet, dass nach der Beendigung der ersten Betriebsart, das heißt ab t = t₁, die Wellenlänge des Pumplichts 28a entsprechend der durch die Ansteuerung mit dem Ansteuerstrom i₂, i₃ bedingten Temperaturzunahme des Diodenlasers 31 zunimmt und somit in den unmittelbaren Bereich der Wellenlänge λₘₐₓ des Absorptionsmaximums des laseraktiven Festkörpers 44 eintritt. Hierdurch ist erfindungsgemäß vorteilhaft gewährleistet, dass während der zweiten Betriebsart und der zugehörigen Ansteuerdauer Δt₂ (Figur 3a), ein möglichst effizientes Pumpen der Lasereinrichtung 26 durch das von dem Diodenlaser 31 erzeugte Pumplicht 28a möglich ist.

Die Ansteuerdauer Δt₂ und der Ansteuerstrom i₂ für die zweite Betriebsart sind erfindungsgemäß vorteilhaft derart gewählt, dass sich in dem laseraktiven Festkörper 44 der Lasereinrichtung 26 eine Besetzurigsinversion aufbaut, und dass sich noch kein Laser-Betrieb während der zweiten Betriebsart einstellt. Entsprechende Werte für den Ansteuerstrom i₂ und die Ansteuerdauer Δt₂ können aus Versuchsmessungen für eine vorgegebene Lasereinrichtung 26 ermittelt und beispielsweise über einen in dem Steuergerät 32 in Form eines Kennfelds niedergelegten Zusammenhang erhalten werden.

Erst die erfindunesgemäße dritte Betriebsart, bei der der Diodenlaser 31 über die Ansteuerdauer Δt₃ mit dem Ansteuerstrom i₃ angesteuert wird, ist dazu vorgesehen, den Laser-Betrieb in dem laseraktiven Festkörper 44 der Lasereinrichtung 26 zu aktivieren und damit die Erzeugung des Laserimpulses 24 auszulösen.

Durch die erfindungsgemäße Trennung zwischen dem Aufbau der Besetzungsinversion während der zweiten Betriebsart und der Auslösung des Laserimpulses 24 während der dritten Betriebsart ist vorteilhaft die Möglichkeit gegeben, den zeitlichen Jitter bei der Erzeugung des Laserimpulse 24 zu minimieren. Dadurch, dass die Ansteuerung des Diodenlasers 31 in der zweiten Betriebsart bewusst die Aktivierung des Laser-Betriebs vermeidet, ist sichergestellt, dass zu dem Zeitpunkt t₂ eine ausreichende Besetzungsinversion in dem laseraktiven Festkörper 44 besteht, so dass die kurzzeitige Beaufschlagung der Lasereinrichtung 26 mit dem Pumplicht 28a, das eine mit dem großen Ansteuerstrom i₃ korrespondierende verhältnismäßig große Intensität aufweist, den Laser-Betrieb aktiviert.

Das heißt, der zeitliche Jitter bei der Erzeugung des Laserimpulses 24 ist vorteilhaft auf die Ansteuerdauer Δt₃ während der dritten Betriebsart beschränkt.

Untersuchungen der Anmelderin zufolge ist ein besonders effizientes Temperieren beziehungsweise Aufheizen des Diodenlasers 31 in der ersten Betriebsart erzielbar, indem der Ansteuerstrom i₁ so gewählt wird, dass er Werte aufweist, die in dem Bereich des Schwellstroms des Diodenlasers 31 liegen. Das heißt, während der ersten Betriebsart wird der Diodenlaser 31 erfindungsgemäß vorteilhaft so betrieben, dass er keine maximale Effizienz hinsichtlich der Erzeugung von Pumplicht 28a aufweist sondern, vielmehr eine schnelle Erwärmung durch die ihm zugeführte Ansteuerenergie erfährt. Der Ansteuerstrom i₁ kann auch kleiner gewählt werden als der Schwellstrom, überschreitet vorzugsweise jedoch nicht das Zweifache des Schwellstroms des Diodenlasers 31.

Die Ermittlung einer Temperatur des Diodenlasers 31 kann in an sich bekannter Weise durch ein integriertes oder sich mit dem Diodenlaser 31 in Wärmekontakt befindendes Thermoelement folgen. Es ist alternativ oder ergänzend hierzu auch möglich, die Temperatur des Diodenlasers 31 abzuleiten aus einem elektrischen Widerstand, der aus dem Ansteuerstrom i und einer zur Ansteuerung des Diodenlasers 31 verwendeten Spannung ermittelbar ist.

Der Zusammenhang zwischen der Temperatur des Diodenlasers 31 und einer Wellenlänge λ des von dem Diodenlaser 31 abgegebenen Pumplichts 28a ist vorteilhaft in einer Kennlinie enthalten, die beispielsweise in dem Steuergerät 32 abgelegt sein kann.

Sofern eine Wärmekapazität des Diodenlasers 31 beziehungsweise der mit ihm in Wärmekontakt stehenden Komponenten hinreichend bekannt ist, kann es zur erfindungsgemäßen Temperierung des Diodenlasers 31 ausreichend sein, eine entsprechende Steuerung während der ersten Betriebsart vorzusehen. Alternativ hierzu kann auch eine Regelung des Diodenlasers 31 auf die Zieltemperatur durchgeführt werden.

Um unnötige Wärmeverluste bei dem Temperieren des Diodenlasers 31 zu vermeiden, wird der Ansteuerstrom i₁ während der ersten Betriebsart innerhalb der vorstehend beschriebenen Grenzen vorzugsweise möglichst groß gewählt, so dass sich eine rasche Erwärmung ergibt. Ebenso ist es vorteilhaft, wenn sich die zweite und gegebenenfalls dritte Betriebsart direkt zeitlich an die erste Betriebsart anschließen, um ein unerwünschtes Abkühlen des Diodenlasers 31 und damit eine erneute Veränderung, insbesondere Verringerung, der Wellenlänge λ des Pumplichts 28a zu vermeiden.

Ein gezieltes Abkühlen des Diodenlasers 31 kann erfindungsgemäß ebenfalls durchgeführt werden, indem der Diodenlaser 31 für eine entsprechende Wartezeit beispielsweise gar nicht mehr angesteuert wird. Innerhalb dieser Wartezeit wird vorteilhaft periodisch die Temperatur des Diodenlasers 31 überprüft, um die Möglichkeit einer erneuten Inbetriebnahme des Diodenlasers 31 mit einer möglichst geringen Latenzzeit feststellen zu können.

Obwohl das erfindungsgemäße Betriebsverfahren vorstehend anhand einer Zündeinrichtung für eine Brennkraftmaschine 10 beschrieben worden ist, kann das erfindungsgemäße Betriebsverfahren auch bei Zündeinrichtungen für Stationärmotoren eingesetzt werden.

Das erfindungsgemäße Prinzip der Temperierung der Pumplichtquelle 30 allein durch eine entsprechende Ansteuerung der Pumplichtquelle 30 beziehungsweise eines darin enthaltenen Diodenlasers 31 kann selbstverständlich auf jede einen Diodenlaser 31 enthaltende Pumplichtquelle 30 beziehungsweise Laserlichtquelle angewandt werden, das heißt insbesondere auch auf solche Laserlichtquellen, die, im Gegensatz zur Erfindung, keinen Einsatz als Pumplichtquelle finden. Durch die erfindungsgemäße "implizite" Temperierung des Diodenlasers 31 mittels einer entsprechenden Ansteuerung ist vorteilhaft eine sehr einfach realisierbare Möglichkeit zur Temperierung und damit zur Einstellung der Wellenlänge des Diodenlasers 31 gegeben.

## Patentansprüche

1. Verfahren zum Betreiben einer Pumplichtquelle (30) mit einem Diodenlaser (31), die ein Pumplicht (28a) zum optischen Pumpen einer Lasereinrichtung (26) bereitstellt, wobei die Pumplichtquelle (30) in einer ersten Betriebsart so angesteuert wird, dass der Diodenlaser (31) eine vorgebbare Zieltemperatur annimmt, bei der das von der Pumplichtquelle (30) erzeugte Pumplicht (28a) eine gewünschte Wellenlänge (λₛₒₗₗ) beziehungsweise eine Wellenlänge (λₘₐₓ) aufweist, die in einem Bereich eines Maximums des Absorptionskoeffizienten des laseraktiven Festkörpers (44) der Lasereinrichtung (26) liegt, wobei ein Ansteuerstrom (i) und eine Ansteuerdauer, vorzugsweise in Abhängigkeit der Zieltemperatur, vorgegeben werden, wobei die Pumplichtquelle (30) in einer auf die erste Betriebsart folgenden zweiten Betriebsart so angesteuert wird, dass sie Pumplicht (28a) erzeugt, um eine Besetzungsinversion in dem laseraktiven Festkörper (44) der Lasereinrichtung (26) aufzubauen, wobei die Pumplichtquelle (30) in einer auf die zweite Betriebsart folgenden dritten Betriebsart so angesteuert wird, dass sie Pumplicht (28a) derart erzeugt, um einen Laser-Betrieb in der Lasereinrichtung (26) zu aktivieren, **dadurch gekennzeichnet, dass** die Pumplichtquelle (30) in der ersten Betriebsart so angesteuert wird, dass sich der Diodenlaser (31) auf eine vorgebbare Zieltemperatur aufheizt.

2. Verfahren nach Anspruch 1, **dadurch gekennzeichnet, dass** der Ansteuerstrom (i) in der ersten Betriebsart so gewählt wird, dass er in dem Bereich eines Schwellstroms des Diodenlasers (31) liegt, wobei der Ansteuerstrom (i) vorzugsweise kleiner oder gleich dem zweifachen Schwellstrom ist.

3. Verfahren nach einem der vorstehenden Ansprüche, **dadurch gekennzeichnet, dass** der Diodenlaser (31) in der ersten Betriebsart auf die Zieltemperatur geregelt wird.

4. Verfahren nach einem der vorstehenden Ansprüche, **dadurch gekennzeichnet, dass** eine Temperatur des Diodenlasers (31) unter Verwendung eines mit dem Diodenlaser (31) in Wärmekontakt stehenden Thermoelements ermittelt und/oder aus einem elektrischen Widerstand des Diodenlasers (31) abgeleitet wird.

5. Verfahren nach einem der vorstehenden Ansprüche, **dadurch gekennzeichnet, dass** der Diodenlaser (31) in der zweiten Betriebsart mit einem Ansteuerstrom (i), angesteuert wird, der, vorzugsweise um ein Vielfaches, größer ist als der Schwellstrom des Diodenlasers (31).

6. Verfahren nach einem der vorstehenden Ansprüche, **dadurch gekennzeichnet, dass** die Pumplichtquelle (30) verwendet wird zum optischen Pumpen einer Lasereinrichtung (26) einer Zündeinrichtung für eine Brennkraftmaschine (10), insbesondere eines Kraftfahrzeugs, wobei die Lasereinrichtung (26) einen laseraktiven Festkörper (44) mit einer passiven Güteschaltung (46) aufweist.

7. Verfahren nach Anspruch 1, **dadurch gekennzeichnet, dass** der Ansteuerstrom (i) und/oder die Ansteuerdauer in der zweiten Betriebsart so gewählt werden, dass sich in der Lasereinrichtung (26) kein Laser-Betrieb einstellt.

8. Verfahren nach Anspruch 1, **dadurch gekennzeichnet, dass** die Ansteuerdauer in der dritten Betriebsart kleiner ist als eine Ansteuerdauer in der zweiten Betriebsart, und/oder dass ein Ansteuerstrom (i) in der dritten Betriebsart größer ist als ein Ansteuerstrom (i) in der zweiten Betriebsart.

9. Verfahren nach einem der vorstehenden Ansprüche, **dadurch gekennzeichnet, dass** ein Zusammenhang zwischen der Temperatur des Diodenlasers (31) und einer Wellenlänge (λ) des Pumplichts (28a) aus einer Kennlinie erhalten wird.

10. Computerprogramm, **dadurch gekennzeichnet, dass** das Computerprogramm zur Durchführung des Verfahrens nach einem der vorstehenden Ansprüche programmiert ist.

11. Steuergerät (32), **dadurch gekennzeichnet, dass** das Steuergerät (32) zur Durchführung des Verfahrens nach einem der Ansprüche 1 bis 9 ausgebildet ist.

## Claims

1. Method for operating a pump light source (30) comprising a diode laser (31), said pump light source providing a pump light (28a) for optically pumping a laser device (26), wherein the pump light source (30) is driven in a first operating mode such that the diode laser (31) is a predefinable target temperature at which the pump light (28a) generated by the pump light source (30) has a desired wavelength (λ_{desired}) or a wavelength (λₘₐₓ) that lies in a region of a maximum of the absorption coefficient of the laser-active solid (44) of the laser device (26), wherein a driving current (i) and a driving duration are predefined, preferably in a manner dependent on the target temperature, wherein the pump light source (30) is driven in a second operating mode, following the first operating mode, such that it generates pump light (28a) in order to build up a population inversion in the laser-active solid (44) of the laser device (26), wherein the pump light source (30) is driven in a third operating mode, following the second operating mode, such that it generates pump light (28a) in such a way as to activate laser operation in the laser device (26), **characterized in that** the pump light source (30) is driven in the first operating mode such that the diode laser (31) heats up to a predefinable target temperature.

2. Method according to Claim 1, **characterized in that** the driving current (i) in the first operating mode is chosen such that it lies in the region of a threshold current of the diode laser (31), wherein the driving current (i) is preferably less than or equal to twice the threshold current.

3. Method according to either of the preceding claims, **characterized in that** the diode laser (31) is regulated to the target temperature in the first operating mode.

4. Method according to any of the preceding claims, **characterized in that** a temperature of the diode laser (31) is determined using a thermoelement in thermal contact with the diode laser (31) and/or is derived from an electrical resistance of the diode laser (31).

5. Method according to either of the preceding claims, **characterized in that** the diode laser (31) is driven in the second operating mode with a driving current (i) which is greater, preferably by a multiple, than the threshold current of the diode laser (31).

6. Method according to either of the preceding claims, **characterized in that** the pump light source (30) is used for optically pumping a laser device (26) of an ignition device for an internal combustion engine (10), in particular of a motor vehicle, wherein the laser device (26) has a laser-active solid (44) with a passive Q-switch (46).

7. Method according to Claim 1, **characterized in that** the driving current (i) and/or the driving duration in the second operating mode are chosen such that laser operation is not established in the laser device (26).

8. Method according to Claim 1, **characterized in that** the driving duration in the third operating mode is less than a driving duration in the second operating mode, and/or **in that** a driving current (i) in the third operating mode is greater than a driving current (i) in the second operating mode.

9. Method according to any of the preceding claims, **characterized in that** a relationship between the temperature of the diode (31) and a wavelength (λ) of the pump light (28a) is obtained from a characteristic curve.

10. Computer program, **characterized in that** the computer program is programmed for carrying out the method according to any of the preceding claims.

11. Control unit (32) **characterized in that** the control unit (32) is designed for carrying out the method according to any of Claims 1 to 9.

## Revendications

1. Procédé de conduite d'une source (30) de lumière de pompage présentant une diode laser (31) qui délivre une lumière de pompage (28a) qui pompe optiquement un dispositif laser (26),
la source (30) de lumière de pompage étant commandée dans un premier mode de fonctionnement dans lequel la diode laser (31) prend une température cible prédéterminée à laquelle la lumière de pompage (28a) produite par la source (30) de lumière de pompage présente une longueur d'onde souhaitée (λₛₒₗₗ) ou une longueur d'onde (λₘₐₓ) située au niveau du maximum du coefficient d'absorption du corps solide (44) à activité laser du dispositif laser (26),
le courant de commande (i) et la durée de commande étant prédéterminés de préférence en fonction de la température,
la source (30) de lumière de pompage étant commandée dans un deuxième mode de fonctionnement qui suit le premier mode de fonctionnement de telle sorte qu'elle produise une lumière de pompage (28a) qui établit une inversion d'occupation dans le corps solide (44) à activité laser du dispositif laser (26),
la source (30) de lumière de pompage étant commandée dans un troisième mode de fonctionnement qui suit le deuxième mode de fonctionnement de telle sorte qu'elle produise une lumière de pompage (28a) qui active un fonctionnement laser dans le dispositif laser (26),
**caractérisé en ce que**
dans le premier mode de fonctionnement, la source (30) de lumière de pompage est commandée de telle sorte que la diode laser (31) s'échauffe à une température cible prédéterminée.

2. Procédé selon la revendication 1, **caractérisé en ce que** le courant de commande (i) sélectionné est situé au niveau du courant de seuil de la diode laser (31) et **en ce que** le courant de commande (i) est de préférence inférieur ou égal au double du courant de seuil.

3. Procédé selon l'une des revendications précédentes, **caractérisé en ce que** dans le premier mode de fonctionnement, la diode laser (31) est régulée à la température cible.

4. Procédé selon l'une des revendications précédentes, **caractérisé en ce que** la température de la diode laser (31) est déterminée en recourant à un thermoélément en contact thermique avec la diode laser (31) et/ou est dérivée de la résistance électrique de la diode laser (31).

5. Procédé selon l'une des revendications précédentes, **caractérisé en ce que** dans le deuxième mode de fonctionnement, la diode laser (31) est commandée par un courant de commande (i) qui est de préférence un multiple du courant de seuil de la diode laser (31).

6. Procédé selon l'une des revendications précédentes, **caractérisé en ce que** la source (30) de lumière de pompage est utilisée pour pomper optiquement le dispositif laser (26) du dispositif d'allumage d'un moteur à combustion interne (10), en particulier celui d'un véhicule automobile, le dispositif laser (26) présentant un corps solide (44) à activité laser doté d'un circuit passif de déclenchement (46).

7. Procédé selon la revendication 1, **caractérisé en ce que** le courant de commande (i) et/ou la durée de commande sélectionnés dans le deuxième mode de fonctionnement sont tels qu'un fonctionnement laser ne s'établisse pas dans le dispositif laser (26).

8. Procédé selon la revendication 1, **caractérisé en ce que** dans le troisième mode de fonctionnement, la durée de commande est plus courte que la durée de commande dans le deuxième mode de fonctionnement et/ou en ce que dans le troisième mode de fonctionnement, le courant de commande (i) est plus élevé que le courant de commande (i) dans le deuxième mode de fonctionnement.

9. Procédé selon l'une des revendications précédentes, **caractérisé en ce que** la dépendance entre la température de la diode laser (31) et la longueur d'onde (λ) de la lumière de pompage (28a) est maintenue à partir d'une ligne caractéristique.

10. Programme informatique **caractérisé en ce que** le programme informatique est programmé pour exécuter le procédé selon l'une des revendications précédentes.

11. Appareil de commande (32) **caractérisé en ce que** l'appareil de commande (32) est configuré pour exécuter le procédé selon l'une des revendications 1 à 9.
